# EUROPÄISCHE PATENTSCHRIFT

(11) **EP 0 471 937 B1**
(45) Veröffentlichungstag und Bekanntmachung des Hinweises auf die Patenterteilung: **06.09.1995**
(21) Anmeldenummer: 91109778.0
(22) Anmeldetag: 14.06.1991
(51) Int. Cl.: H05K 1/03, C08K 3/02, C08K 3/32, B32B 15/14, C08J 5/24

(54) **Träger für Kupferfolien von flexiblen Leiterplatten**
Substrates for copper foils of flexible circuit boards
Substrats pour feuilles en cuivre de plaquettes à circuit flexibles

(30) Priorität: 21.08.1990 DE 4026354
(43) Veröffentlichungstag der Anmeldung: 26.02.1992
(73) Patentinhaber: Firma Carl Freudenberg, 69469 Weinheim (DE)
(72) Erfinder: Hausdorf, Jörg, W-6942 Mörlenbach (DE); Kuhlmann, Thomas, Dr., W-6900 Heidelberg (DE); Schneider, Rolf, W-6140 Bensheim-Zell (DE); Kosack, Steffen, Dr., W-6733 Hassloch (DE); Schäfer, Werner, W-6943 Birkenau (DE); Siekermann, Volker, Dr., W-6149 Fürth (DE)

(56) Entgegenhaltungen:
- EP-A- 0 119 617
- WO-A-85/05626
- DATABASE WPIL Section Ch, Week 8412, Derwent Publications Ltd., London, GB;Class A, AN 84-071081

## Beschreibung

Die Erfindung betrifft die Verwendung eines beschichteten und imprägnierten Vliesstoffs oder Papiers als flammfesten, thermostabilen Träger für Kupferfolien von flexiblen Leiterplatten.

Das konventionelle Ausgangsmaterial für flexible Leiterplatten besteht aus einer temperatur- und dimensionsstabilen Isolationsfolie (z.B. Polyester oder Polyimid), auf die mittels einer Kleberschicht die Kupferfolie ein- oder beidseitig haftfest laminiert wird.

Die Schwachstelle dieses Materialverbundes ist die Kleberschicht, die nur unter Beimischung von halogenierten Flammschutzmitteln schwer brennbar oder selbstverlöschend ausgerüstet werden kann.

Man versuchte daher, kleberfreie flexible Basismaterialien herzustellen. Ein solches Verfahren wird in EP-B-14 444 beschrieben. Als Polymer wird flüssiges, härtbares Polyesterharz eingesetzt, welches in Lösungsmittel gelöst und zur Tränkung eines Vliesstoffs oder Papiers benutzt wird. Auf das getränkte Vlies oder Papier wird eine Kupferfolie gebracht und dieser Verbund unter Anwendung von Druck und Temperatur verpreßt. Um diesen Verbund mit selbstverlöschenden Eigenschaften auszurüsten, sind bromierte Flammschutzmittel erforderlich. Ferner besteht der Nachteil, daß zur Herstellung des Basismaterials umweltbelastende Lösungsmittel eingesetzt werden müssen und die Entsorgung des Basismaterials oder der flexiblen Leiterplatten aus den gleichen Gründen problematisch ist. Im Brandfall wird die Entstehung von bromhaltigen Dioxinen diskutiert.

Aus WO-A-85 05 626 ist eine flammhemmende Zusammensetzung auf Basis eines ethylenisch ungesättigten Copolymers bekannt, welches zusätzlich Melamin, einen gesättigten aliphatischen Polyol sowie roten Phosphor und Ammoniumpolyphosphat enthält.

Der Erfindung liegt die Aufgabe zugrunde, ein imprägniertes bzw. beschichtetes, kleberfreies Basismaterial aus Vliesstoff oder Papier zu entwickeln, das ohne Zuhilfenahme von Lösungsmitteln und halogenierten Flammschutzmitteln flammfest nach UL 94-V0 ausgerüstet und hergestellt werden kann, wobei auch die Lötbadfestigkeit von 290°C/20 s und die Schälfestigkeit zwischen Vliesstoff bzw. Papier und Kupferfolie über 0,7 N/mm nach IPC-Norm gewährleistet sein müssen.

Diese Aufgabe wird gelöst durch die Verwendung mit den Merkmalen des Patentanspruches 1. Derart beschichtete und imprägnierte Vliesstoffe oder Papiere dienen als Träger für Kupferfolien, d.h. als Basismaterial für flexible Leiterplatten. Mit denselben Anforderungen soll es möglich sein, sogar fertige Leiterbilder auf dem Vliesstoff-Träger sicher, ohne Zwischenschichten, zu fixieren.

Das Verhältnis der 50%igen wäßrigen Dispersion des Copolymerisats zu der 60%igen wäßrigen, Methylolgruppen enthaltenden Lösung eines Aminoplast-Vorkondensats muß sich trocken zwischen 10:0,8 und 10:2,0 bewegen, um ein chemisches Vernetzungsprodukt zu erhalten; ein höherer Anteil des Vorkondensats führt zu spröden Beschichtungen und neigt zur Blasenbildung, während eine Erniedrigung zu einer zu geringen Vernetzungsdichte führt.

Um die geforderte flammhemmende Eigenschaft nach UL 94 (Klasse V0) zu erfüllen, wird dem Vernetzungssystem eine feindisperse Flammschutzmischung auf Basis roter Phosphor und Ammoniumpolyphosphat (Verhältnis 1:10) in einem Verhältnis von 1:0,9 zugesetzt. Die Korngröße des roten Phosphors beträgt üblicherweise 0,045 bis 0,10 mm, diejenige des Ammoniumpolyphosphats 0,025 bis 0,075 mm.

Eine höhere oder niedrigere Phosphorkonzentration führt zu Beschichtungen, die die Anforderungen an UL 94 V0 nicht mehr erfüllen; ebenso ist eine feindisperse Verteilung der Flammschutzmischung im Vernetzungssystem notwendig.

Die eingangs charakterisierten Komponenten werden in einem schnellaufenden Rührwerk vermischt. Die Beschichtung bzw. Imprägnierung kann gleich gut durch Bürsten, Rakeln, Streichen oder Drucken aufgetragen werden. Anschließend wird getrocknet. Es werden Vlies- und Kupferzuschnitte hergestellt oder entsprechende Bahnenware beschichtet und nach dem Trocknen gegebenenfalls unter Druck und Wärme, z.B. in einer Presse, miteinander haftend verbunden.

Die Rohstoffe, d.h. das Copolymerisat aus Acrylsäureester und Styrol, die Vorkondensat-Lösung, der rote Phosphor und das Ammoniumpolyphosphat, sind im Handel erhältlich. Ihre Eignung als getrennt voneinander einzusetzende Komponenten für Beschichtungs-, Kaschier- und Klebezwecke ist bekannt. Unvorhersehbar war jedoch, daß die kombinierte Verwendung dieser Mischungsbestandteile in Verbindung mit dem halogenfreien Flammschutzsystem bei der Beschichtung und Imprägnierung auf einem Vliesstoff oder Papier - nach der Vernetzung - zu einem Material führt, welches das hohe Anforderungsprofil für flexible Leiterplatten, wie z.B. die Lötbadbeständigkeit (290°C/20 s), das Brandverhalten (gemäß UL 94 V0) und die Schälfestigkeit zwischen Vliesstoff und Kupfer (über 0,7 N/mm) nach IPC-Norm erfüllt.

Es ist im Rahmen der Erfindung möglich, zwei verschiedene Typen von wäßrigen Dispersionen des Copolymerisats aus Acrylsäureester und Styrol miteinander zu vermischen; von dieser Verbindungsklasse sind solche unterschiedlichen Typen im Handel erhältlich. Das Abmischen geschieht zu dem Zweck, die Flexibilität der Imprägnierung und somit des Vliesstoffs sowie dessen Naßhaftung gegenüber der Kupferfolie zu optimieren, wobei durch Vorversuche jeweils mühelos das jeweils geeignete Mischungsverhältnis der Copolymerisat-Dispersionen ermittelt werden kann.

Das Beschichtungssystem ist wäßriger Natur und enthält keine halogenhaltigen Flammschutzmittel; es entfallen somit Schutz- und Entsorgungsmaßnahmen, wie sie bisher beim Einsatz von Lösungsmitteln und halogenhaltigen Flammschutzmitteln erforderlich waren.

Die Auftragsmenge beträgt 30 bis 60 g/m² (trocken). Weitere Vorteile sind Trocknungszeiten schon bei Raumtemperatur von durchschnittlich 10 Minuten und die Tatsache, daß die beschichtete und getrocknete Flächenware, d.h. der thermostabile, imprägnierte Vliesstoff und die Kupferfolie, vor der Herstellung des Verbundes wochenlang lagerfähig ist, ohne daß das Beschichtungssystem seine vorteilhaften Qualitäten und Wirkungen einbüßt.

Eine Alternative der erfindungsgemäßen Verwendung sieht vor, ein Basismaterial für flexible Leiterplatten dadurch herzustellen, daß die Kupferfolie vollflächig auf den Vliesstoffträger laminiert wird und auf dem so entstandenen Basismaterial die Leiterbahnen nach bekannten Ätzprozessen ausgebildet werden. Die weitere Handhabung des Basismaterials ist also völlig unproblematisch; es hält allen Anforderungen der weiteren Bearbeitung stand, wie dies bei konventionellen Basismaterialien von flexiblen gedruckten Schaltungen der Fall ist und in den Beispielen zahlenmäßig belegt wird.

Eine besonders bevorzugte Variante der Erfindung besteht darin, die Kupferfolie als vorgefertigtes Leiterbild auf den Vliesstoffträger zu laminieren. Es entfallen die teuren und aufwendigen Ätzprozesse, was auch vom ökologischen Standpunkt von Vorteil ist. Es sind Breiten der individuellen Leiterbahnen bis hinab zu 0,2 mm unproblematisch zu verarbeiten.

Die folgenden Beispiele zeigen typische Eigenschaften des Verbundes einer Kupferfolie für flexible Leiterplatten mit einem Vliesstoff, dessen Daten sind:

### Polyamid-Polyester-Bindefasermischung

- Flächengewicht:: 49 g/m²
- Dicke:: 0,071 mm
- Höchstzugkraft:: 134 N
- Dehnung:: 24 %
- Luftdurchlässigkeit:: 207 dm³/s/m²

Das Copolymerisat aus Acrylsäureester und Styrol in 50%iger Dispersion, das Melaminharzformaldehyd-Vorkondensat, Phosphorpulver und Ammoniumpolyphosphat werden mit Wasser und einem Farbstoff in einem schnellaufenden Rührwerk in verschiedenen Anteilen gemäß der nachfolgenden Tabelle vermischt. Die Beschichtung und Imprägnierung geschieht durch Bestreichen des Vliesstoffs in einer Auftragsmenge von 40 g/m² (trocken). Die Trocknung erfolgt bei 110°C innerhalb von 10 Minuten. Es werden Vliesstoff- und Kupferzuschnitte hergestellt und nach dem Trocknen unter Druck und Wärme in einer Presse bei 200°C miteinander haftend verbunden. Die Schälfestigkeit zwischen Vliesstoff und Kupfer, die Lötbadbeständigkeit des Verbundes, das Brandverhalten und die Oberfläche nach dem Verpressen werden geprüft. Die Komponenten für die Dispersion sind im Handel erhältlich: Das Copolymerisat aus Acrylsäureester und Styrol in 50%iger Dispersion unter der Bezeichnung Acronal S 886 S oder Acronal 12 DE (BASF), das Melaminharzformaldehyd-Vorkondensat unter der Bezeichnung Cassurit F (Hoechst), das rote Phosphorpulver in einer Korngröße zwischen 0,045 bis 0,10 mm als Exolit 405 (Hoechst) und das Ammoniumpolyphosphat mit einer mittleren Korngröße von 0,025 bis 0,075 mm als Exolit 422 (Hoechst).

Ergebnisse von Versuchen bestätigen, daß die erfindungsgemäße Verwendung eines beschichteten und imprägnierten Vliesstoffs die Anforderungen an ein Basismaterial sowie einen mit fertigen Leiterbahnen belegten Träger für flexible gedruckte Schaltungen voll erfüllt.

## Patentansprüche

1. Verwendung eines Vliesstoffs oder Papiers, welches beschichtet und imprägniert ist mit dem chemischen Vernetzungsprodukt aus
a) der 50%igen, wäßrigen Dispersion eines thermisch vernetzbaren Copolymerisats mit einer Glasübergangstemperatur von + 33°C aus Acrylsäureester und Styrol und aus
b) der 60%igen, wäßrigen, Methylolgruppen enthaltenden Lösung eines Amino- oder Phenoplast-Vorkondensats, in Verbindung mit
c) rotem Phosphor mit einer Korngröße von 0,045 bis 0,10 mm und
d) Ammoniumpolyphosphat mit einer Korngröße von 0,025 bis 0,075 mm, wobei die Auftragsmenge (trocken) 30 bis 60 g/m² beträgt,
als Träger für Kupferfolien von flexiblen Leiterplatten, wobei das Verhältnis von a:b (trocken) 10:0,8 bis 10:2,0, das Verhältnis von c:d 1:10 und das Verhältnis von (a + b) zu (c + d) 1:0,9 beträgt.

2. Verwendung eines Vliesstoffs gemäß Anspruch 1, dadurch gekennzeichnet, daß die Kupferfolie vollflächig auf den Vliesstoffträger laminiert wird und auf dem so entstandenen Basismaterial die Leiterbahnen nach bekannten Ätzprozessen ausgebildet werden.

3. Verwendung eines Vliesstoffs gemäß Anspruch 1, dadurch gekennzeichnet, daß die Kupferfolie als vorgefertigtes Leiterbild auf den Vliesstoffträger laminiert wird.

## Claims

1. Use of a nonwoven material or paper which has been coated and impregnated with the product of the chemical crosslinking of
a) the 50% strength, aqueous dispersion of a thermally crosslinkable acrylate-styrene copolymer having a glass transition temperature of +33°C and
b) the 60% strength, aqueous, methylol group-containing solution of an amino or phenolic resin precondensate, in combination with
c) red phosphorus having a particle size of from 0.045 to 0.10 mm and
d) ammonium polyphosphate having a particle size of from 0.025 to 0.075 mm, where the application rate (dry) is from 30 to 60 g/m²,
as substrate for copper foils of flexible circuit boards, where the a:b (dry) ratio is from 10:0.8 to 10:2.0, the c:d ratio is 1:10 and the (a+b):(c+d) ratio is 1:0.9.

2. Use of a nonwoven material according to Claim 1, characterized in that the copper foil is laminated onto the nonwoven material substrate over the entire surface, and the conductor tracks are formed on the resultant base material by known etching processes.

3. Use of a nonwoven material according to Claim 1, characterized in that the copper foil is laminated, as a prefabricated conductor pattern, onto the nonwoven material substrate.

## Revendications

1. Utilisation d'un non-tissé ou de papier qui a été enduit et imprégné avec le produit de réticulation chimique constitué par
a) la dispersion aqueuse à 50% d'un copolymère thermoréticulable possédant une température de transition vitreuse de +33°C, d'ester acrylique et de styrène et par
b) la solution d'un précondensat d'amino- ou de phénoplaste, aqueuse à 60%, contenant des groupes méthylol, en liaison avec
c) du phosphore rouge ayant une granulométrie de 0,045 à 0,10 mm et
d) du polyphosphate d'ammonium ayant une granulométrie de 0,025 à 0,075 mm, la quantité d'application (à l'état sec) s'élevant de 30 à 60 g/m²,
comme support pour des feuilles en cuivre de plaquettes de circuits imprimés flexibles, dans laquelle le rapport a:b (à l'état sec) s'élève de 10:0,8 à 10:2,0, le rapport c:d s'élève à 1:10 et le rapport de (a + b) à (c + d) s'élève à 1:0,9.

2. Utilisation d'un non-tissé selon la revendication 1, caractérisée en ce qu'on lamine la feuille de cuivre sur toute la surface du support en non-tissé et on réalise les pistes conductrices sur la matière de base ainsi obtenue, conformément à des procédés de gravure connus.

3. Utilisation d'un non-tissé selon la revendication 1, caractérisée en en ce qu'on lamine la feuille de cuivre sur le support en non-tissé sous forme d'un plaquage métallique sélectif préfabriqué.
